Europäisches Patentamt

European Patent Office

Office européen des brevets

(19)

(11) Publication number: **0 106 564**

**A1**

(12) # EUROPEAN PATENT APPLICATION

(21) Application number: 83305583.3

(22) Date of filing: 21.09.83

(51) Int. Cl.³: **H 05 K 3/30**
    **H 05 K 13/04**

(30) Priority: 21.09.82 JP 164401/82

(43) Date of publication of application:
    25.04.84 Bulletin 84/17

(84) Designated Contracting States:
    DE

(71) Applicant: **Matsushita Electric Industrial Co., Ltd.**
    **1006, Oaza Kadoma**
    **Kadoma-shi Osaka-fu, 571(JP)**

(72) Inventor: **Maeda, Yukio**
    **1-44-30 Himurodai**
    **Hirakata Osaka 573-01(JP)**

(72) Inventor: **Hohchin, Ryuzoh**
    **4-107, Tohdacho**
    **Moriguchi Osaka 570(JP)**

(74) Representative: **Crawford, Andrew Birkby et al,**
    **A.A. THORNTON & CO. Northumberland House 303-306**
    **High Holborn**
    **London WC1V 7LE(GB)**

(54) A manufacturing method for a printed wiring substrate and a heater therefor.

(57) A manufacturing method for assembling a printed wiring substrate comprises the steps of disposing microelectronic parts onto a printed wiring substrate (3) by means of an adhesive, blowing cold air from an inlet (12) onto the printed wiring substrate (3) while heating the parts from above the substrate (3) by use of infrared ray heaters (8), and soldering the substrate (3), so that the influence of cold air minimizes temperature rise at the printed wiring substrate and moreover the adhesive is curable in a short time.

FIG.3.

EP 0 106 564 A1

SPECIFICATION

Title of the Invention

A manufacturing method for a printed wiring substrate and a heater therefor.

Technical Field

This invention relates to a manufacturing method
for a printed wiring substrate and a heater therefor
which is available for radio receivers or television
receivers, and aims at provision of a manufacturing
method for a printed wiring substrate, which reduces a
temperature rise at the printed wiring substrate as much
as possible to ensure curing of an adhesive in a short
time.

Background Art

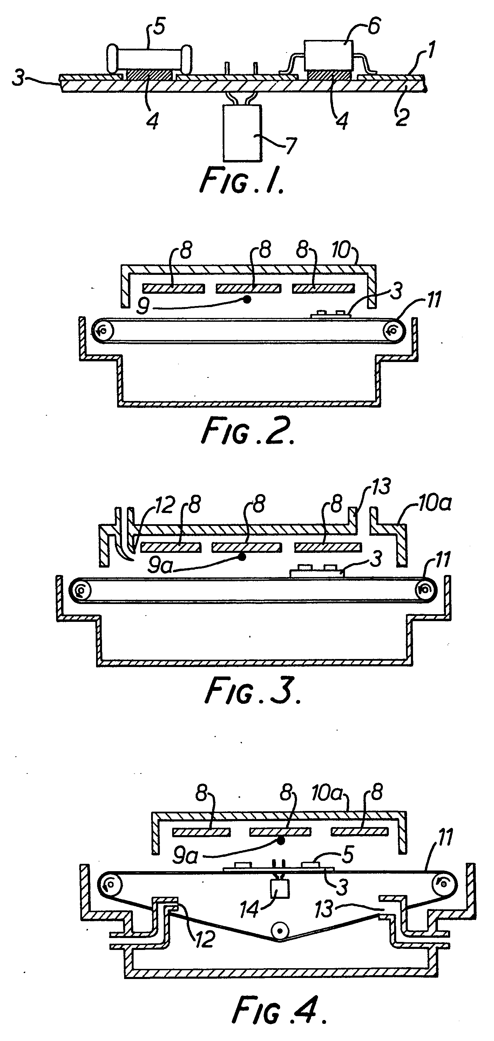

Generally, when microelectronic parts are mounted
on the printed wiring substrate, a method has widely
been used, in which a phenolic resin laminated plate 2
with a copper foil pattern 1 is coated with an adhesive
4 as shown in Fig. 1, microelectronic parts (to be hereinafter called the chip parts) 5 and 6 are placed on the
adhesive 4, the adhesive reacts to be cured by heating
or both heating and radiation of ultraviolet rays, and
the chip parts 5 and 6 are fixed on a printed wiring substrate 3 and thereafter soldered thereto.  In this case,
epoxy resin series and acrylic resin series mainly are used as the adhesive, and a curing temperature has to
be raised in order to use a small-sized conveyor type
continuous curing apparatus for reduction of curing time
period. On the other hand, copper foil is subjected at
the surface easily to oxidization as its temperature
rises, thereby causing poor soldering. In some cases,
an electronic part 7 with lead wires is previously
inserted into insertion bores from the surface of printed
wiring substrate 3 carrying no chip part, some electronic
parts with lead wires being lower in heat resistance.
Hence, it has been preferable to cure the adhesive at a
high temperature and in a short time and not to heat
the printed wiring substrate and electronic parts with
lead wires as much as possible.

The conventional adhesive curing method and an
apparatus therefor, as shown in Fig. 2, have placed a
printed wiring substrate 3 on a conveyor 11 and heated
it from above by use of far infrared ray heaters 8 and
a heater control temperature sensor 9 are fixed to an
outer casing 10 of furnace body, the heater control
temperature sensor 9 having usually been disposed in a
position where an atmosphere under the far infrared ray
heaters 8 and above the printed wiring substrate 3 is
measurable. Such conventional adhesive curing method,
however, heats the printed wiring substrate 3 and electronic part 7 with lead wires simultaneously with heating the
adhesive 4, whereby a heating temperature for the printed
wiring substrate is limited to thereby create a problem
in that it is difficult to reduce an adhesive curing
time period.

Disclosure of the Invention

This invention aims at the provision of a manufacturing method for a printed wiring substrate, comprising
processes of placing microelectronic parts on a printed
wiring substrate through an adhesive, blowing cold air
onto the surface of printed wiring substrate about
simultaneously with heating the same from above by use
of infrared ray heaters, and soldering the printed wiring
substrate. This invention is particularly advantageous
in that the influence of cold air minimizes a temperature
rise at the printed wiring substrate and moreover the
adhesive is curable in a short time.

These and other object of the invention will become
more apparent in the detailed description and examples
which follow.

Brief Description of the Drawings

Fig. 1 is a sectional view of a printed wiring
panel, Fig. 2 is a sectional view of a heating apparatus
for a conventional printed wiring substrate, and Figs. 3
and 4 are sectional views of heating apparatus for embodiments of the invention.

Detailed Description of Preferred Embodiment

Next, an embodiment of the invention will be detailed. Referring to Fig. 3, an embodiment of a manufacturing method for a printed wiring substrate of the invention is shown, in which a printed wiring substrate 3 carrying chip parts is placed on a conveyor 11 and heated from above by use of far infrared ray heaters to thereby cure an adhesive, a heater control sensor 9 being brought into contact with one far infrared ray heater 8 and fixed thereto. An outer casing 10a for the furnace body is provided with a cold air inlet 12 and an exhaust outlet 13, the cold air inlet 12 being directed at its nozzle toward the exhaust outlet 13 so that cold air after cooling the printed wiring substrate 3 is exhausted, through the exhaust outlet 13 not to flow into a working chamber. The exhaust air from the outlet 13 is desirable to be larger in amount than cold air taken in through the inlet 12, and the nozzle thereof should be positioned in the direction of allowing the cold air to effectively strike the surface of printed wiring substrate 3, the cold air being preferable to be cooled by a cooler, but usual air blast need only be available. The printed wiring substrate 3 is adapted to be placed on the conveyor 11 and move continuously leftwardly in the Figure. In this

- 5 -          0106564

method, when the adhesive below the microelectronic parts
is heated, the infrared rays radiated from the heaters
8 have the permeability to reach not only the surface
of printed wiring substrate but also the adhesive below
the microelectronic parts, thereby heating the adhesive
also.  However, the printed wiring substrate 3, which is
cooled by cold air, can be restricted in its temperature
rise to a minimum, and the adhesive is not struck
directly by the cold air thanks to the existence of
microelectronic parts.  Therefore, the temperature rise
at the printed wiring substrate 3 is minimized and the
adhesive can sufficiently be heated, thereby enabling
to heat the adhesive by the intense infrared rays in a
short time.

Next, explanation will be given with reference to Fig.4 on the curing of
adhesive in such a manner that the chip parts 5 are
loaded on the upper surface of printed wiring substrate
3 and an electrolytic capacitor 14 is inserted into the
lower surface of the same so that the substrate 3 is
placed on the conveyor 11 and heated from above by the
far infrared ray heaters 8.  In this case, the heater
control temperature sensor 9 is provided in contact with
the surface of one far infrared ray heater 8, and a cold
air inlet 12 is provided below the printed wiring substrate 3 to prevent the temperature rise at the electrolytic capacitor inferior in heat resistance. In a case where the surface of printed wiring substrate 3 is kept in a temperature of about 150°C for 30 seconds, the air blast from the inlet could keep the surface temperature of electrolytic capacitor under 100°C, but in a case of no air blast, the temperature of the same rose up to 130°C. Thus, the adhesive on the upper surface of substrate 3 can sufficiently be heated to be cured in a short time because the printed wiring substrate 3 is cooled at the lower surface thereof only.

The infrared ray heater for the invention is desirable to have a wavelength of 20 through 30 µm, such wavelength being given effectively by keeping the surface temperature of heater at a temperature of 300 to 1000°C. The embodiment of the invention provides the heater control sensor in contact with the surface of heater, whereby no temperature drop of sensor occurs by the cold air and the infrared rays can properly be selected by intensity and wavelength thereof.

The adhesive in use for the invention need only be of heat curing property so that epoxy resin series, acrylic resin series, and phenolic resin series are available.

Alternatively, the cold air inlet and exhaust outlet may be plural in number, or be provided above and below the printed wiring substrate 3. Also, the exhaust outlet is preferable to be one or more, but may be replaced by natural exhaust air through an opening at the outer casing of the furnace body.

Also, in a case of using both the heating and ultraviolet ray radiation for curing the adhesive, the cold air blast is possible as the same as aforesaid.

Industrial Applicability

As seen from the above, this invention is characterized in that the microelectronic parts are placed onto the printed wiring substrate through the adhesive, the infrared ray heaters heat the parts from above the printed wiring substrate, and cold air is blown from above or below the printed wiring substrate onto the surface thereof, thereby minimizing a temperature rise at the printed wiring substrate and electronic parts and the adhesive is cured in a short time. Thus, the invention is improvable of reliability and productivity and very effective in practical use.

CLAIMS:

1. A manufacturing method for a printed wiring panel comprising processes of disposing microelectronic parts onto a printed wiring substrate through an adhesive, blowing cold air onto the surface or the back of said printed wiring substrate about simultaneously with heating said adhesive from above said printed wiring substrate by use of infrared ray heaters to an extent of enabling curing of said adhesive, and soldering said printed wiring substrate.

2. A heating device for a printed wiring substrate, which is provided with infrared ray heaters, an outer furnace casing, a conveyor for a printed wiring substrate, a blast inlet, and a temperature sensor.

3. A heating device for a printed wiring substrate according to claim 2, being provided also with an exhaust outlet.

4. A heating device for a printed wiring substrate according to claim 3, wherein a nozzle of said blast inlet is directed toward said exhaust outlet.

5. A heater for a printed wiring substrate according to claim 3, wherein an amount of exhaust air from said exhaust outlet is somewhat larger than that from said blast inlet.

6. A manufacturing method for a printed wiring substrate according to claim 1, wherein a surface temperature of each of said infrared ray heaters is kept in a temperature of 300 through 1000°C.

7. A heating device for a printed wiring substrate according to claim 2, wherein said heater control temperature sensor is provided in contact with the surface of said heater.

1/1

FIG.1.

FIG.2.

FIG.3.

FIG.4.

European Patent
Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | US-A-3 717 742 (FOTTLER) <br> * Claims 1, 2; column 2, line 33 - column 3, line 20; figures 1-7 * <br><br> --- | 1,2 | H 05 K 3/30 <br> H 05 K 13/04 |
| A | GB-A-2 047 973 (SONY) <br> * Claims 1, 5, 6; page 1, lines 78-101; figures 1-3 * <br><br> --- | 1 | |
| A | GB-A-2 014 791 (HITACHI) <br><br> * Page 3, lines 75-94; figures 1, 2 * <br><br> ----- | | |

**TECHNICAL FIELDS SEARCHED (Int. Cl. ³)**

H 01 L 21/58
H 05 K 3/00
H 05 K 3/30
H 05 K 13/04

The present search report has been drawn up for all claims

| Place of search <br> BERLIN | Date of completion of the search <br> 14-12-1983 | Examiner <br> HAHN G |
|---|---|---|